# FASCICULE DE BREVET EUROPEEN

(11) **EP 0 704 903 B1**
(45) Date de publication et mention de la délivrance du brevet: **17.12.2003**
(21) Numéro de dépôt: 95410113.5
(22) Date de dépôt: 25.09.1995
(51) Int. Cl.: H01L 27/06

(54) **Composant semiconducteur d'alimentation, de recirculation et de démagnétisation d'une charge selfique**
Halbleitervorrichtung zur Speisung, Rückleitung und Entmagnetisierung einer induktiven Last
Semiconductor component for the supply, recirculation and demagnetisation of an inductive load

(30) Priorité: 30.09.1994 FR 9411975
(43) Date de publication de la demande: 03.04.1996
(73) Titulaire: STMicroelectronics S.A., 92120 Montrouge (FR)
(72) Inventeur: Siaudeau, Jean-Louis, F-13720 Belcodene (FR); Pavlin, Antoine, F-13540 Puyricard (FR)
(74) Mandataire: de Beaumont, Michel

(56) Documents cités:
- EP-A- 0 352 238
- EP-A- 0 409 746
- EP-A- 0 622 849

## Description

La présente invention vise à la réalisation d'un composant monolithique assurant les fonctions d'alimentation, de recirculation et de démagnétisation d'une charge selfique par une technologie spécifique utilisée pour la fabrication de transistors MOS verticaux de puissance.

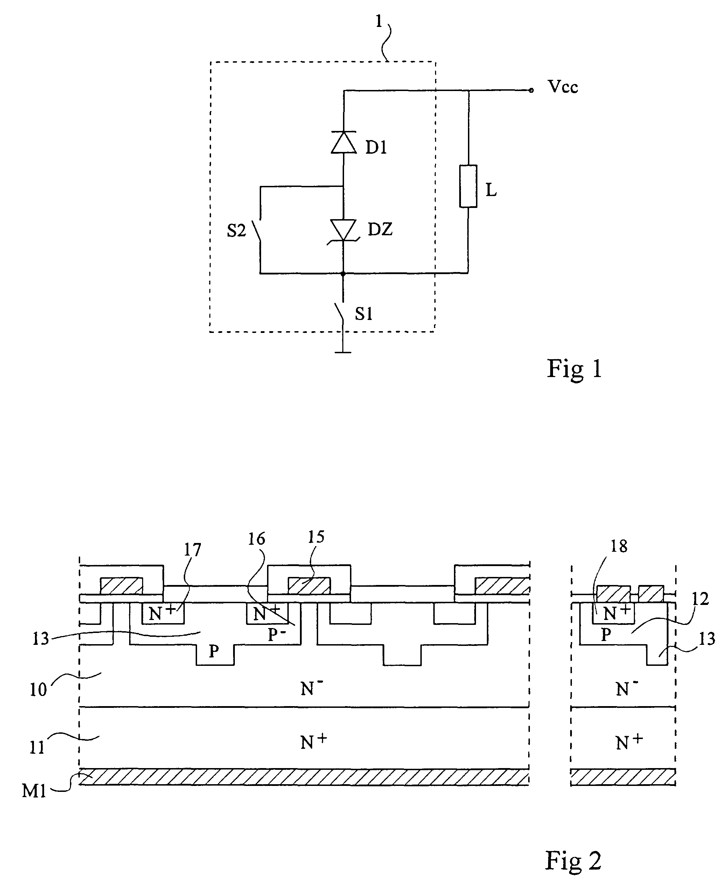

On va d'abord rappeler, en relation avec la figure 1, la configuration habituelle d'un circuit d'alimentation, de recirculation et de démagnétisation d'une charge selfique et, ensuite, en relation avec la figure 2, les principales caractéristiques d'une technologie de fabrication de transistors de puissance verticaux.

La figure 1 représente la configuration classique d'un circuit d'alimentation, de recirculation et de démagnétisation d'une charge selfique. Dans cette figure, la charge L est connectée entre une alimentation continue Vcc et la masse par l'intermédiaire d'un interrupteur S1. Aux bornes de la charge L sont disposés en série une diode D1 et un interrupteur S2. Une diode zener DZ est en parallèle sur l'interrupteur S2.

On distingue dans ce circuit trois phases de fonctionnement :
- une phase d'excitation pendant laquelle l'interrupteur S1 est fermé et où l'état de l'interrupteur S2 est indifférent ; pendant cette phase, un courant d'alimentation circule dans la charge L ;
- une phase de recirculation au cours de laquelle l'interrupteur S1 est ouvert et l'interrupteur S2 est fermé ; pendant cette phase, l'énergie stockée dans la charge L recircule sous forme d'un courant passant par cette charge, la diode D1 et l'interrupteur S2 ; et
- une phase de démagnétisation au cours de laquelle les interrupteurs S1 et S2 sont ouverts ; pendant cette phase, le courant continue à recirculer par la diode D1 et la diode zener DZ jusqu'à démagnétisation complète de la charge inductive.

La figure 2 illustre la technologie dans laquelle la demanderesse souhaite réaliser un circuit assurant les fonctions de celui illustré en figure 1. Cette technologie permet de fabriquer des circuits comprenant des transistors MOS verticaux (VDMOS) et des caissons logiques dans lesquels peuvent être incorporés divers circuits logiques MOS. Cette technologie se caractérise par le fait qu'elle est très simple et comporte un nombre minimum d'étapes de traitement et notamment d'étapes de masquage et de diffusion.

La figure 2 représente de façon très schématique l'allure de composants de puissance réalisables dans la technologie considérée. La partie gauche de la figure représente des cellules d'un transistor VDMOS et la partie droite un transistor NPN vertical.

Dans cette technologie, on part d'un substrat comprenant une couche 10 de type N formée par épitaxie sur une plaquette de silicium monocristallin 11 de type N⁺.

Dans une première étape de dopage, on forme des régions de type P destinées à former, d'une part, des caissons logiques (non représentés) dans lesquels seront réalisés les circuits logiques du composant, d'autre part, par exemple, des régions de base 12 de transistors NPN verticaux telles que celle représentée dans la partie droite de la figure 2.

Dans une deuxième étape de dopage, on forme des régions P⁺ à niveau de dopage suffisamment élevé pour obtenir un contact ohmique avec des métallisations. On forme ainsi des régions 13 qui en figure 2 correspondent à une région de reprise de contact de source du VDMOS et à une région de reprise de contact de base pour le transistor bipolaire. Dans les figures, ces régions à niveau de dopage élevé sont symbolisées par le fait qu'elles sont plus profondes.

Ensuite, on forme de façon classique, par exemple par oxydation, dépôt de silicium polycristallin, gravure et réoxydation, les grilles 15 des transistors VDMOS et d'autres transistors non représentés dans la partie logique du circuit.

Dans une troisième étape de dopage (avant la susdite étape de réoxydation) on forme des régions de type P faiblement dopées, masquées par la grille des transistors VDMOS, à la périphérie supérieure desquelles se développent les régions de canal du transistor VDMOS.

Dans une quatrième étape de dopage on réalise des régions de type N fortement dopé. On forme ainsi des régions de source 17 du transistor de puissance et des régions d'émetteur 18 des transistors bipolaires, ainsi que diverses régions (non représentées) de source et de drain des transistors logiques et de reprise de contact avec le substrat.

Enfin, on forme des métallisations de source, de drain, de base, de collecteur et d'émetteur aux endroits appropriés sur la surface du substrat. Ces métallisations ne portent pas de référence dans la figure, pas plus que les régions d'oxyde déposées pour isoler des portions superficielles du composant. Les métallisations (ou couches de silicium polycristallin) sont désignées par des hachures. La face arrière du substrat est uniformément revêtue d'une métallisation M1.

On prévoit aussi éventuellement des étapes de dopage supplémentaires au niveau des composants formés dans la partie logique, par exemple une étape de formation de canal pour des transistors MOS déplétés.

On ne décrira pas le fonctionnement d'un transistor VDMOS qui est bien connu dans la technique. On notera seulement que, bien qu'en figure 2 on n'ait représenté qu'un petit nombre de cellules d'un transistor VDMOS, généralement un transistor VDMOS de puissance est constitué d'un grand nombre de cellules, par exemple 100 à plus de 1000.

Si on examine à nouveau la partie entourée d'un cadre en pointillés 1 du circuit de la figure 1, on s'aperçoit que ce circuit 1 n'est pas réalisable sous forme de composant monolithique en utilisant la technologie simple décrite en relation avec la figure 2, notamment du fait que la face arrière du circuit de la figure 2 est constituée d'une couche 11 de type N fortement dopée uniformément revêtue d'une métallisation M1.

De plus, le circuit de la figure 1 présente certains inconvénients. En particulier, la présence d'une diode D1 en série avec le commutateur S2 pendant la phase de recirculation entraîne qu'une certaine chute de tension apparaît aux bornes de cette diode (0,6 à 0,8 volt) en plus de la chute de tension existant inévitablement dans le commutateur S2 réalisé sous forme d'un composant semiconducteur tel qu'un transistor VDMOS ou un transistor bipolaire NPN. Cette chute de tension est une composante majeure de la consommation du circuit. Un autre circuit est décrit dans EP-A-352238.

La présente invention telle que revendiquée dans la revendication 1 vise à réaliser un circuit assurant des fonctions d'alimentation d'une charge inductive, de recirculation du courant dans cette charge et de démagnétisation exempt des inconvénients susmentionnés et réalisable sous forme de composant monolithique.

Pour atteindre ces objets, la présente invention prévoit un composant semiconducteur de commutation d'une charge inductive, comprenant des première et deuxième bornes extérieures, des première et deuxième bornes de commande et un noeud de connexion, un transistor bipolaire vertical ayant une base, disposé entre la première borne extérieure et le noeud, un premier transistor vertical entre le noeud et la deuxième borne extérieure, une diode zener et un deuxième transistor vertical connectés en parallèle entre la base et le noeud.

Selon un mode de réalisation de la présente invention, les premier et deuxième transistors verticaux sont des transistors MOS.

Selon un mode de réalisation de la présente invention, le composant comprend un transistor MOS latéral dont la grille reçoit une troisième tension de commande et dont la source et le drain sont respectivement connectés à la deuxième borne extérieure et à la base du transistor bipolaire.

Selon un mode de réalisation de la présente invention, le composant comprend, du côté de la surface supérieure d'un substrat de type N dont la face arrière est revêtue d'une région de type N fortement dopée et d'une métallisation, des cellules d'un premier transistor MOS vertical dont la source est reliée à la deuxième borne extérieure et la grille à la première tension de commande, des cellules d'un deuxième transistor MOS vertical dont la grille reçoit une tension de commande, une région de base et une région d'émetteur d'un transistor bipolaire vertical, la région d'émetteur étant connectée à la première borne extérieure et la région de base étant reliée à la source des cellules du deuxième transistor MOS vertical, un caisson de type P relié à la région de base du transistor bipolaire vertical, et une région de cathode de type N formée dans le caisson de type P, constituant avec le matériau du caisson une diode zener, et reliée au potentiel du substrat.

Selon un mode de réalisation de la présente invention, le composant comprend, du côté de la surface supérieure d'un substrat de type N dont la face arrière est revêtue d'une région de type N fortement dopée et d'une métallisation, une région de base et une région d'émetteur d'un premier transistor bipolaire vertical, la région d'émetteur étant connectée à la deuxième borne extérieure, une région de base et une région d'émetteur d'un deuxième transistor bipolaire vertical, une région de base et une région d'émetteur d'un troisième transistor bipolaire vertical, la région d'émetteur étant connectée à la première borne extérieure et la région de base étant reliée à la région d'émetteur du deuxième transistor bipolaire, un caisson de type P relié à la région de base du troisième transistor bipolaire vertical, et une région de cathode de type N formée dans le caisson de type P, constituant avec le matériau du caisson une diode zener, et reliée au potentiel du substrat.

Ces objets, caractéristiques et avantages ainsi que d'autres de la présente invention seront exposés en détail dans la description suivante de modes de réalisation particuliers faite à titre d'exemple non limitatif en relation avec les figures jointes parmi lesquelles :
la figure 1 illustre un circuit classique que la présente invention vise à réaliser sous forme de composant monolithique ;
la figure 2 représente une vue en coupe de portions d'un composant semiconducteur pour illustrer une technologie dans laquelle la présente invention vise à réaliser un circuit assurant les fonctions du circuit de la figure 1 ;
la figure 3 représente un circuit d'alimentation, de recirculation et de démagnétisation d'une charge inductive selon la présente invention ;
la figure 4 représente une vue en coupe schématique et simplifiée d'un composant mettant en oeuvre le circuit de la figure 3 selon la présente invention ;
la figure 5 représente une variante du circuit de la figure 3 dans laquelle tous les interrupteurs sont réalisés sous forme de transistors bipolaires ; et
la figure 6 représente une vue en coupe schématique et simplifiée d'un composant mettant en oeuvre le circuit de la figure 5.

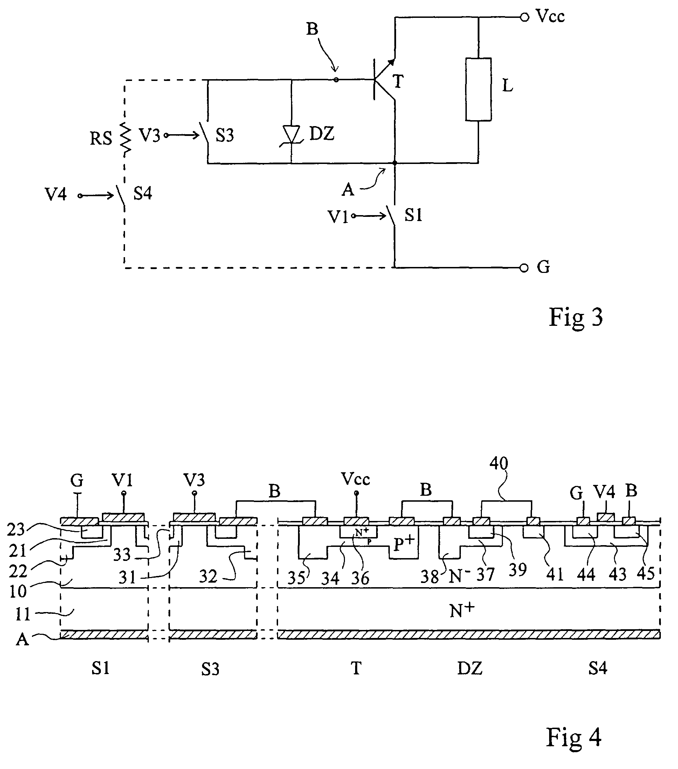

Dans le circuit de la figure 3, une charge L est connectée entre une borne d'alimentation continue positive Vcc et un noeud A du circuit qui est également relié à la masse G par l'intermédiaire d'un commutateur S1. Entre les bornes A et Vcc est disposé un transistor bipolaire T de type NPN dont l'émetteur est relié à la borne Vcc et le collecteur à la borne A. Entre la base B du transistor T et le noeud A est disposé un commutateur S3 en parallèle avec une diode zener DZ . En outre, le circuit comprend optionnellement un commutateur S4 en série avec une résistance Rs entre le noeud B et la masse G.

Comme le circuit de la figure 1, le circuit de la figure 3 est susceptible d'assurer trois phases de fonctionnement.

Dans une phase d'excitation, le commutateur S1 est fermé et un courant d'alimentation circule dans la charge L.

Dans une phase de recirculation, le commutateur S1 est ouvert et le commutateur S3 est fermé. Le courant dans la charge L tend à se maintenir en circulant dans la boucle contituée initialement par le commutateur S3 et la jonction base-émetteur du transistor T. Dès que cette boucle s'amorce, le transistor T devient passant et le courant circule dans la charge et le transistor T.

Dans une phase de démagnétisation, les commutateurs S1 et S3 sont ouverts et le courant s'arrête de circuler dès que la démagnétisation de la charge est réalisée.

De préférence, le commutateur S4 est fermé pendant les phases de démagnétisation, pour que, quand la circulation de courant est interrompue dans le transistor T, le potentiel de base reste fixé.

Un premier avantage du circuit illustré en figure 3 est que, pendant la phase de recirculation, la puissance consommée dans le circuit est plus faible que celle consommée dans le circuit de la figure 1. En effet, la chute de tension entre la borne VCC et le noeud A correspond à la chute de tension base/émetteur du transistor bipolaire T (environ 0,7 V) plus la chute de tension négligeable provoquée par la circulation du courant de base dans le commutateur S3. Par contre, dans le circuit de la figure 1, il faut ajouter la chute de tension dans une diode en direct (de l'ordre de 0,6 à 0,8 volt) à la chute de tension dans le commutateur S2 (environ 0,4 volt pour un transistor MOS). Ainsi, la chute de tension aux bornes des éléments du composant servant à la recirculation sera environ deux fois plus faible pour un courant donné dans le cas du circuit selon la présente invention par rapport au cas du circuit de l'art antérieur. En conséquence, la surface des éléments du composant alloués à cette fonction pourra être environ deux fois plus faible.

Un deuxième avantage du circuit illustré en figure 3 est qu'il est réalisable sous forme d'un composant semiconducteur monolithique fabriqué selon la technologie décrite en relation avec la figure 2.

La figure 4 illustre un exemple de réalisation d'un tel composant. Le composant est réalisé dans une couche épitaxiée 10 formée sur un substrat 11 de type N⁺ revêtu d'une métallisation de face inférieure qui correspond au drain des transistors MOS verticaux et aux collecteurs des transistors bipolaires verticaux, c'est-à-dire comme on le verra ci-après au noeud de connexion A du circuit de la figure 3.

Dans la partie gauche de la figure 4, on a représenté une portion de cellule d'un transistor MOS vertical assurant la fonction de commutateur S1. Ce transistor MOS vertical comprend un caisson de canal 21 de type P associé à une région de type P plus fortement dopée 22 et une région de source 23 de type N. Une métallisation G est solidaire des régions 22 et 23 et une grille reliée à une source de tension de commande V1 est disposée au-dessus de la région de canal.

Un deuxième transistor MOS vertical, comprenant des régions 31, 32, 33 correspondant respectivement aux régions 21, 22, 23, constitue le commutateur S3. La métallisation de source reliée à la base B du transistor T est désignée par cette référence. La grille est reliée à une source de tension de commande V3.

Le transistor bipolaire T comporte une région de base de type P 34 associée à une région plus fortement dopée 35. Une région d'émetteur 36 est formée dans la région de base 34. La région 36 est en contact avec une métallisation reliée à la source de tension Vcc.

Dans une région 37 de type P solidaire d'une région plus fortement dopée 38, est formée une région 39 de type N. la région 38 est reliée par une métallisation B aux régions 32 et 35. La région 39 est reliée par une métallisation 40 à une région 41 de type N⁺ formée directement dans le substrat 10. Ainsi la région 39 est en relation de conduction par l'intermédiaire du substrat 10 et de la couche 11 avec la métallisation de face arrière A. On obtient donc entre les régions 39 et 37 une diode zener dont la cathode est reliée à la borne A et dont l'anode est reliée à la borne B.

On a donc obtenu de façon simple une structure comprenant les composants S1, S3, DZ et T reliés de la façon illustrée en figure 3. On notera que la diode zener DZ a une résistance série non négligeable associée à l'épaisseur du substrat 10. Toutefois, ceci ne constitue pas un inconvénient en pratique puisque la diode zener DZ n'est pas destinée à véhiculer un courant important mais seulement à provoquer éventuellement la mise en conduction du transistor bipolaire T. Ceci aussi constitue un avantage de la présente invention par rapport à l'art antérieur où la diode DZ doit être dimensionnée pour tolérer le passage d'un courant non négligeable.

Enfin, le commutateur S4 peut être réalisé sous forme d'un transistor MOS latéral formé dans un caisson 43 de type P disposé dans le substrat 10 et comprenant des régions de source et de drain 44 et 45. La métallisation de source est reliée à la borne G, la métallisation de drain à la borne D et la métallisation de grille à une source de commande V4.

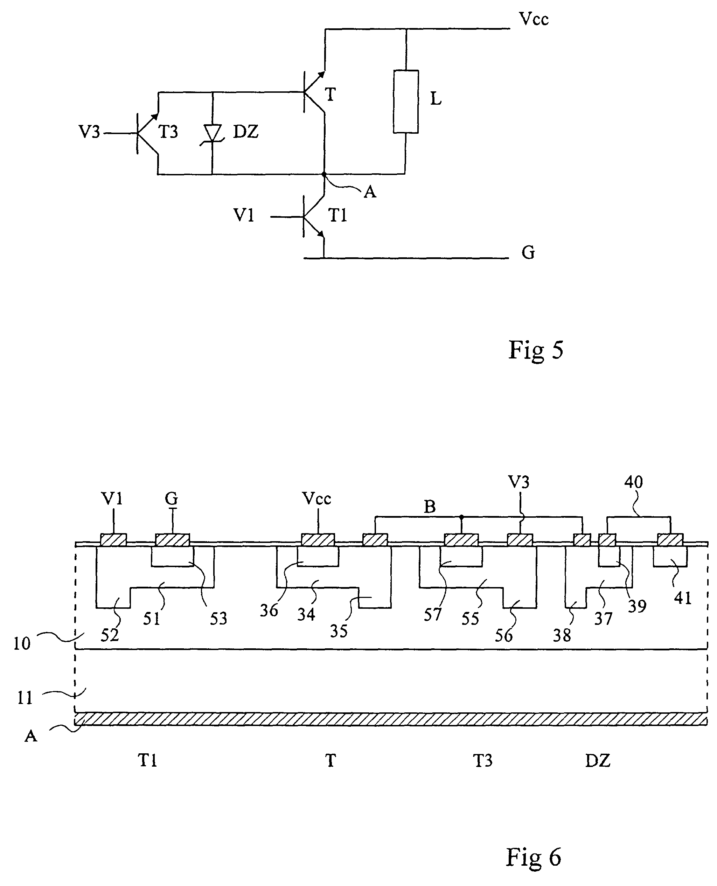

La figure 5 représente une variante du circuit de la figure 3 dans laquelle tous les interrupteurs sont réalisés sous forme de transistors bipolaires. Ainsi les interrupteurs S1 et S3 de la figure 3 sont représentés sous forme de transistors NPN T1 et T3.

La figure 6 représente une vue en coupe schématique et simplifiée d'un composant mettant en oeuvre le circuit de la figure 5. Dans cette figure, des couches, régions et caissons identiques à ceux de la figure 4 sont désignés par de mêmes références. En particulier les éléments de réalisation du transistor T et de la diode zener DZ sont les mêmes qu'en figure 4. Le transistor MOS latéral correspondant au commutateur S4 n'a pas été représenté mais pourrait également être prévu.

Le transistor NPN T1 est réalisé sous forme verticale et comprend une région de base 51, 52 et une région d'émetteur 53. La région d'émetteur est connectée à la borne extérieure G et la région de base à la tension de commande V1.

Le transistor NPN T3 est réalisé sous forme verticale et comprend une région de base 55, 56 et une région d'émetteur 57. La région d'émetteur est connectée à la borne B et la région de base à la tension de commande V3.

L'homme de métier saura choisir la disposition et la surface relative des diverses régions et le nombre de cellules des transistors MOS pour satisfaire aux exigences de transmission de courant visées.

## Revendications

1. Composant semiconducteur de commutation d'une charge inductive, comprenant :
des première et deuxième bornes extérieures (Vcc, G), des première et deuxième bornes de commande (V1, V3) et un noeud de connexion (A),
un transistor bipolaire vertical (T) ayant une base (B), disposé entre la première borne extérieure (Vcc) et ledit noeud (A),
un premier transistor vertical (S1) entre ledit noeud (A) et la deuxième borne extérieure, la borne de commande de ce premier transistor correspondant à la première borne de commande (V1), et
une diode zener (DZ) et un deuxième transistor vertical (S3) connectés en parallèle entre ladite base et le noeud (A), la borne de commande de ce deuxième transistor correspondant à la deuxième borne de commande (V3).

2. Composant semiconducteur selon la revendication 1, **caractérisé en ce que** les premier et deuxième transistors verticaux (S1, S3) sont des transistors MOS.

3. Composant semiconducteur selon la revendication 1, **caractérisé en ce qu'**il comprend en outre un transistor MOS latéral (S4) dont la grille reçoit une troisième tension de commande et dont la source et le drain sont respectivement connectés à la deuxième borne extérieure et à la base du transistor bipolaire.

4. Composant semiconducteur selon la revendication 2, **caractérisé en ce qu'**il comprend, du côté de la surface supérieure d'un substrat de type N dont la face arrière est revêtue d'une région de type N fortement dopée et d'une métallisation (A) :
des cellules (21, 22, 23) d'un premier transistor MOS vertical dont la source est reliée à la deuxième borne extérieure (G) et la grille à la première tension de commande,
des cellules (31, 32, 33) d'un deuxième transistor MOS vertical dont la grille reçoit une tension de commande (V3),
une région de base (34, 35) et une région d'émetteur (36) d'un transistor bipolaire vertical, la région d'émetteur étant connectée à la première borne extérieure (Vcc) et la région de base étant reliée à la source des cellules du deuxième transistor MOS vertical,
un caisson (37, 38) de type P relié à la région de base du transistor bipolaire vertical, et
une région de cathode de type N (39) formée dans le caisson de type P, constituant avec le matériau du caisson une diode zener, et reliée au potentiel du substrat.

5. Composant semiconducteur selon la revendication 4, **caractérisé en ce que** la région de cathode (39) est reliée par une métallisation (40) à une région (41) de type N fortement dopée formée dans le substrat.

6. Composant semiconducteur selon la revendication 4, **caractérisé en ce qu'**il comprend un transistor MOS latéral formé dans un caisson supplémentaire (43) disposé dans le substrat, la source de ce transistor MOS latéral étant connectée à la deuxième borne extérieure (G) et son drain à la base du transistor bipolaire.

7. Composant semiconducteur selon la revendication 1, **caractérisé en ce qu'**il comprend, du côté de la surface supérieure d'un substrat de type N dont la face arrière est revêtue d'une région de type N fortement dopée et d'une métallisation (A) :
une région de base (51, 52) et une région d'émetteur (53) d'un premier transistor bipolaire vertical (T1), la région d'émetteur étant connectée à la deuxième borne extérieure (G),
une région de base (55, 56) et une région d'émetteur (57) d'un deuxième transistor bipolaire vertical (T3),
une région de base (34, 35) et une région d'émetteur (36) d'un troisième transistor bipolaire vertical (T), la région d'émetteur étant connectée à la première borne extérieure (Vcc) et la région de base étant reliée à la région d'émetteur du deuxième transistor bipolaire,
un caisson (37, 38) de type P relié à la région de base du troisième transistor bipolaire vertical, et
une région de cathode de type N (39) formée dans le caisson de type P, constituant avec le matériau du caisson une diode zener, et reliée au potentiel du substrat.

8. Composant semiconducteur selon la revendication 7, **caractérisé en ce que** la région de cathode (39) est reliée par une métallisation (40) à une région (41) de type N fortement dopée formée dans le substrat.

9. Composant semiconducteur selon la revendication 7, **caractérisé en ce qu'**il comprend un transistor MOS latéral formé dans un caisson supplémentaire (43) disposé dans le substrat, la source de ce transistor MOS latéral étant connectée à la deuxième borne extérieure (G) et son drain à la base du troisième transistor bipolaire.

## Claims

1. A semiconductor component for switching an inductive load, comprising:
first and second external terminals (Vcc, G), first and second control terminals (V1, V3) and a node (A),
a vertical bipolar transistor (T) having a base region (B) and disposed between the first external terminal (Vcc) and said node (A),
a first vertical transistor (S1) disposed between said node (A) and the second external terminal, the control terminal of the first transistor corresponding to the first control terminal (V1), and
a zener diode (DZ) and a second vertical transistor (S3) which are connected in parallel between said base and the node (A), the control terminal of the second transistor corresponding to the second control terminal (V3).

2. The semiconductor component of claim 1, **characterized in that** the first and second vertical transistors (S1, S3) are MOS transistors.

3. The semiconductor component of claim 1, **characterized in that** it further comprises a lateral MOS transistor (S4) , whose gate receives a third control voltage and whose source and drain are connected to the second external terminal and to the base of the bipolar transistor, respectively.

4. The semiconductor component of claim 2, **characterized in that** it comprises, on the upper surface of an N-type substrate, whose rear surface is coated with a highly doped N-type region and a metallization (A):
cells (21, 22, 23) of a first vertical MOS transistor, having a source connected to the second external terminal (G) and a gate connected to the first control voltage;
cells (31, 32, 33) of a second vertical MOS transistor, whose gate receives a control voltage (V3),
a base region (34, 35) and an emitter region (36) of a vertical bipolar transistor, the emitter region being connected to the first external terminal (Vcc) and the base region being connected to the source of the cells of the second vertical MOS transistor,
a P-type well (37, 38) connected to the base region of the vertical bipolar transistor, and
an N-type cathode region (39) formed in the P-type well, which constitutes a zener diode with the material of the well, and is connected to the substrate voltage.

5. The semiconductor component of claim 4, **characterized in that** the cathode region (39) is connected through a metallization (40) to a highly doped N-type region (41) formed in the substrate.

6. The semiconductor component of claim 4, **characterized in that** it comprises a lateral MOS transistor formed in an additional well (43) disposed in the substrate, the source of said lateral MOS transistor being connected to the second external terminal (G) and its drain being connected to the base of the bipolar transistor.

7. The semiconductor component of claim 1, **characterized in that** it comprises, on the upper surface of an N-type substrate, whose rear surface is coated with a highly doped N-type region and with a metallization (A) :
a base region (51, 52) and an emitter region (53) of a first vertical bipolar transistor (T1), the emitter region being connected to the second external terminal (G),
a base region (55, 56) and an emitter region (57) of a second vertical bipolar transistor (T3),
a base region (34, 35) and an emitter region (36) of a third vertical bipolar transistor (T), the emitter region being connected to the first external terminal (Vcc) and the base region being connected to the emitter region of the second bipolar transistor,
a P-type well (37, 38) connected to the base region of the third vertical bipolar transistor, and
an N-type cathode region (39) formed in the P-type well, constituting with the material of the well a zener diode, and connected to the substrate voltage.

8. The semiconductor component of claim 7, **characterized in that** the cathode region (39) is connected through a metallization (40) to a highly doped N-type region (41) formed in the substrate.

9. The semiconductor component of claim 7, **characterized in that** it comprises a lateral MOS transistor formed in an additional well (43) disposed in the substrate, the source of said lateral MOS transistor being connected to the second external terminal (G) and its drain being connected to the base of the third bipolar transistor.

## Patentansprüche

1. Halbleiterkomponente zum Schalten einer induktiven Last, welche aufweist:
einen ersten und einen zweiten externen Anschluß (Vcc, G), einen ersten und einen zweiten Steuerungsanschluß (V1, V3) und einen Verbindungsknoten (A),
einen vertikalen bipolaren Transistor (T) mit einer Basis (B), der zwischen dem ersten externen Anschluß (Vcc) und dem Knoten (A) angeordnet ist,
einen ersten vertikalen Transistor (S1), der zwischen dem Knoten (A) und dem zweiten externen Anschluß angeordnet ist und mit dem ersten Steuerungsanschluß (V1) verbunden ist;
eine Zener-Diode (DZ) und einen zweiten vertikalen Transistor (S3), die in Parallelschaltung mit der Basis und dem Knoten (A) verbunden sind, und der mit dem zweiten Steuerungsanschluß (V3) verbunden ist.

2. Halbleiterkomponente nach Anspruch 1, **dadurch gekennzeichnet, daß** der erste und der zweite vertikale Transistor (S1, S3) MOS-Transistoren sind.

3. Halbleiterkomponente nach Anspruch 1, **dadurch gekennzeichnet, daß** sie desweiteren einen lateralen MOS-Transistor (S4) aufweist, dessen Gate eine dritte Steuerungsspannung empfängt und dessen Source und Drain mit dem zweiten externen Anschluß bzw. mit der Basis des bipolaren Transistors verbunden sind.

4. Halbleiterkomponente nach Anspruch 2, **dadurch gekennzeichnet, daß** sie auf der oberen Oberfläche eines N-Typ-Substrates, dessen Rückoberfläche mit einer hochdotierten N-Typ-Region und einer Metallisierung (A) beschichtet ist, aufweist:
Zellen (21, 22, 23) eines ersten vertikalen MOS-Transistors, dessen Source mit dem zweiten externen Anschluß (G) verbunden ist und dessen Gate mit der ersten Steuerungsspannung verbunden ist;
Zellen (31, 32, 33) eines zweiten vertikalen MOS-Transistors, dessen Gate eine Steuerungsspannung (V3) empfängt,
eine Basisregion (34, 35) und eine Emitterregion (36) eines vertikalen bipolaren Transistors, wobei die Emitterregion mit dem ersten externen Anschluß (Vcc) verbunden ist und die Basisregion mit der Source der Zellen des zweiten vertikalen MOS-Transistors verbunden ist,
eine P-Typ-Senke (37, 38), die mit der Basisregion des vertikalen bipolaren Transistors verbunden ist, und
eine N-Typ-Kathodenregion (39), die in dem P-Typ-Bereich gebildet ist, die mit dem Material des Bereichs eine Zener-Diode bildet, und welche mit der Substratspannung verbunden ist.

5. Halbleiterkomponente nach Anspruch 4, **dadurch gekennzeichnet, daß** die Kathodenregion (39) durch eine Metallisierung (40) mit einer hochdotierten N-Typ-Region (41) verbunden ist, die in dem Substrat gebildet ist

6. Halbleiterkomponente nach Anspruch 4, **dadurch gekennzeichnet, daß** sie einen lateralen MOS-Transistor aufweist, der in einem zusätzlichen Bereich (43) gebildet ist, der in dem Substrat angeordnet ist, wobei die Source dieses lateralen MOS-Transistors mit dem zweiten externen Anschluß (G) verbunden ist und seine Drain mit der Basis des bipolaren Transistors verbunden ist.

7. Halbleiterkomponente nach Anspruch 1, **dadurch gekennzeichnet, daß** sie auf der oberen Oberfläche eines N-Typ-Substrats, dessen Rückoberfläche mit einer hochdotierten N-Typ-Region und mit einer Metallisierung (A) beschichtet ist, aufweist:
eine Basisregion (51, 52) und eine Emitterregion (53) eines ersten vertikalen bipolaren Transistors (T1), wobei die Emitterregion mit dem zweiten externen Anschluß (G) verbunden ist,
eine Basisregion (55, 56) und eine Emitterregion (57) eines zweiten vertikalen bipolaren Transistors (T3),
eine Basisregion (34, 35) und eine Emitterregion (36) eines dritten vertikalen bipolaren Transistors (T), wobei die Emitterregion mit dem ersten externen Anschluß (Vcc) verbunden ist und die Basisregion mit der Emitterregion des zweiten bipolaren Transistors verbunden ist,
eine P-Typ-Senke (37, 38), die mit der Basisregion des dritten vertikalen bipolaren Transistors verbunden ist, und
eine N-Typ-Kathodenregion (39), die in dem P-Typ-Bereich gebildet ist, welche mit dem Material des Bereichs eine Zener-Diode bildet und mit der Substratspannung verbunden ist.

8. Halbleiterkomponente nach Anspruch 7, **dadurch gekennzeichnet, daß** die Kathodenregion (39) durch eine Metallisierung (40) mit einer hochdotierten N-Typ-Region (41) verbunden ist, die in dem Substrat gebildet ist.

9. Halbleiterkomponente nach Anspruch 7, **dadurch gekennzeichnet, daß** sie einen lateralen MOS-Transistor aufweist, der in einem zusätzlichen Bereich (43) gebildet ist, der in dem Substrat angeordnet ist, wobei die Source des lateralen MOS-Transistors mit dem zweiten externen Anschluß (G) verbunden ist und seine Drain mit der Basis des dritten bipolaren Transistors verbunden ist.
